# EUROPEAN PATENT APPLICATION

(11) **EP 2 184 613 A1**
(43) Date of publication of application: **12.05.2010**
(21) Application number: 08827503.7
(22) Date of filing: 05.08.2008
(51) Int. Cl.: G01R 29/10, G01R 29/08

(54) **HAND PHANTOM FOR EVALUATING MOBILE COMMUNICATION DEVICE**

(30) Priority: 15.08.2007 JP 2007211845
(71) Applicant: NTT DoCoMo, Inc., Chiyoda-ku Tokyo 100-6150 (JP)
(72) Inventor: KURITA, Daisuke, Tokyo 100-6150 (JP); OKUMURA, Yukihiko, Tokyo 100-6150 (JP); KIRA, Fumio, Tokyo 100-6150 (JP); NAKAMATSU, Shin, Tokyo 100-6150 (JP)
(74) Representative: HOFFMANN EITLE
(86) International application number: PCT/JP2008/064041
(87) International publication number: WO 2009/022580

(57) **Abstract**

A hand phantom for evaluating a mobile apparatus disclosed wherein the hand phantom includes a thumb part, an index finger part, a middle finger part, a ring finger part and a pinky finger part, and in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.2 mm in the X direction and ±12.1 mm in the Y direction around a coordinate (X, Y)=(-1 mm, 7 mm) in the XY coordinate system.

## Description

### TECHNICAL FIELD

The present invention relates to an anthropomorphic human body or phantom and more specifically relates to arrangement of a hand phantom used to evaluate radio characteristics, antenna performance and/or others for a mobile apparatus operating in a data communication mode.

### BACKGROUND ART

In evaluation of antenna performance of mobile apparatuses, a phantom or anthropomorphic human body is used for measurements so that the evaluation can be conducted in a state close to actual usage state of the mobile apparatuses. Since the mobile apparatus such as a cellular phone is used closely to a human body, there are many cases where the human body may affect the antenna performance significantly. For this reason, it is important to measure antenna characteristics with high accuracy in consideration of the affection of the human body.

Until now, generally assuming that a mobile apparatus is in communication, a human head model, which is called SAM (Specific Anthropomorphic Mannequin head phantom) designed in consideration of influences of blocking and reflection and/or absorption of radio waves by a human head, has been studied and developed. The SAM phantom has been standardized in IEC (International Electrotechnical Commission).

The antenna performance of mobile apparatuses may be strongly affected by human hands, and thus studies of hand phantoms beings. In most cases, the shapes of the hand phantoms are designed based on premise of a communication state.

However, functional enhancement of cellular phones increases occasions of the cellular phone being used for not only voice communications but also data communications. For example, cellular phones may be used for web browsing and email communications (data communication mode) more frequently than for voice communications. For this reason, it becomes more important to evaluate mobile apparatuses (radio communication terminals) under the state where the mobile apparatuses are used in the data communication mode.

For this demand, a phantom apparatus including a trunk, a head, arms and hands is proposed for supporting a radio communication apparatus such as a PDA in the front of the trunk and enabling such a posture that the phantom apparatus looks into the screen. For example, see Japan Laid-Open No. 2004-286735. In the case where a radio communication apparatus is held in the data communication mode, an antenna in the radio communication apparatus are located more distantly from the human body than the case where the radio communication apparatus or cellular phone is pressed on the ear in talking mode. Accordingly, a phantom apparatus having a posture specific to the data communications is provided. Such a phantom apparatus has a head slightly tilting forward with respect to the vertical direction and an arm and a hand supporting the radio communication apparatus in the front of the trunk. The head is designed to be longitudinally rotatable with respect to the radio communication apparatus, and the hand is designed to be rotatable around the arm so that the radio communication apparatus can have variable slope angle with respect to the horizontal plane.

The above document is focused on the posture for the data communication mode, and the positions and angles of the head and the hand can be adjusted with respect to the radio communication apparatus. However, the document fails to disclose specific finger positions for holding the radio communication apparatus.

### DISCLOSURE OF INVENTION

### [PROBLEM TO BE SOLVED BY THE INVENTION]

An embedded type of antennas is presently prevalent and is installed in a housing where manipulation keys (pointing device array) of the mobile apparatus are arranged. As a result, in the case where the mobile apparatus is held in the data communication mode, finger positions may affect the antenna performance significantly.

Thus, one object of the present invention is to provide a hand phantom that properly simulates the finger positions for holding the mobile apparatus while the mobile apparatus being in use in the data communication mode is actually held by a hand and enables the antenna characteristics (radio performance) of the mobile apparatus to be measured accurately.

### [MEANS FOR SOLVING THE PROBLEM]

A first aspect of the present invention relates to a hand phantom for evaluating a mobile apparatus, wherein the hand phantom includes a thumb part, an index finger part, a middle finger part, a ring finger part and a pinky finger part, and in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.2 mm in the X direction and ±12.1 mm in the Y direction around a coordinate (X, Y)=(-1 mm, 7 mm) in the XY coordinate system.

A second aspect of the present invention relates to a hand phantom for evaluating a mobile apparatus, wherein the hand phantom includes a thumb part, an index finger part, a middle finger part, a ring finger part and a pinky finger part, the pinky finger part is arranged such that a ball of the pinky finger part is prevented from touching to a side surface of the mobile apparatus in measurement of the mobile apparatus, and in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.3 mm in the X direction and ±13.0 mm in the Y direction around a coordinate (X, Y)=(2 mm, 8 mm) in the XY coordinate system.

A third aspect of the present invention relates to a hand phantom for evaluating a mobile apparatus, wherein the hand phantom includes a thumb part, an index finger part, a middle finger part, a ring finger part and a pinky finger part, and in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.3 mm in the X direction and ±12.6 mm in the Y direction around a coordinate (X, Y)=(0 mm, 8 mm) in the XY coordinate system.

A fourth aspect of the present invention relates to a hand phantom manufacturing method, comprising: processing statistical data regarding a position of a thumb in a first holding pattern of holding a mobile apparatus and determining a first average position and a first standard deviation of the thumb relative to a center of a pointing device array in the mobile apparatus; processing statistical data regarding a position of the thumb in a second holding pattern of holding the mobile apparatus and determining a second average position and a second standard deviation of the thumb relative of the center of the pointing device array; and determining an arranged position of the thumb based on at least one of the first average position and the second average position and the first standard deviation and/or the second standard deviation corresponding to the at least one of the first average position and the second average position and manufacturing a hand phantom for evaluating the mobile apparatus.

### [ADVANTAGE OF THE INVENTION]

According to the aspects of the present invention, various types of mobile apparatuses can be evaluated under actual usage states where data communications such as Web browsing or emails are conducted in the mobile apparatuses, resulting in more accurate evaluation of antenna characteristics.

### BRIEF DESCRIPTION OF DRAWINGS

FIG. 1 schematically illustrates a first holding pattern during usage of a mobile apparatus in a data communication mode;
FIG. 2 schematically illustrates a second holding pattern during usage of a mobile apparatus in a data communication mode;
FIG. 3 illustrates positional relationship among individual fingers with respect to a mobile apparatus in the first holding pattern;
FIG. 4 schematically illustrates a hand phantom for evaluating a mobile apparatus corresponding to the first holding pattern;
FIG. 5 illustrates positional relationship among individual fingers with respect to a mobile apparatus in the second holding pattern;
FIG. 6 schematically illustrates a hand phantom for evaluating a mobile apparatus corresponding to the second holding pattern; and
FIG. 7 illustrates positional relationship among individual fingers averaged for the first and second holding patterns.

### LIST OF REFERENCE SYMBOLS

10, 20: mobile apparatus evaluating hand phantom
11, 21: thumb part
12, 22: index finger part
13, 23: middle finger part
14, 24: ring finger part
15, 25: pinky finger part
50: mobile apparatus
50b: mobile apparatus body
51: mobile apparatus back surface
52: pointing device array
53: decision key (multifunction key or scroll key)
54: mobile apparatus front surface
55: mobile apparatus side surface

### BEST MODE FOR CARRYING OUT THE INVENTION

Preferred embodiments of the present invention are described with reference to the drawings in detail below.

The inventors have found that there are generally two holding patterns for a mobile apparatus used in a data communication mode corresponding to usage types. The inventors have conceived that hand phantoms suitable for one or both of the holding patterns can be designed and used to measure and evaluate antenna performance (radio characteristics) of mobile apparatuses with higher accuracy. One of the holding patterns is typically for usage of Web browsing, and the other is typically for usage of emails. Since fingers are differently put depending on the holding patterns, reflection and absorption may differently affect the antenna of the mobile apparatus. Thus, hand phantoms shaped suitably for one or both of the holding patterns are provided.

A first aspect of the present invention relates to a hand phantom for evaluating a mobile apparatus, wherein the hand phantom includes a thumb part, an index finger part, a middle finger part, a ring finger part and a pinky finger part, and in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.2 mm in the X direction and ±12.1 mm in the Y direction around a coordinate (X, Y)=(-1 mm, 7 mm) in the XY coordinate system.

A second aspect of the present invention relates to a hand phantom for evaluating a mobile apparatus, wherein the hand phantom includes a thumb part, an index finger part, a middle finger part, a ring finger part and a pinky finger part, the pinky finger part is arranged such that a ball of the pinky finger part is prevented from touching to a side surface of the mobile apparatus in measurement of the mobile apparatus, and in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.3 mm in the X direction and ±13.0 mm in the Y direction around a coordinate (X, Y)=(2 mm, 8 mm) in the XY coordinate system.

A third aspect of the present invention relates to a hand phantom for evaluating a mobile apparatus, wherein the hand phantom includes a thumb part, an index finger part, a middle finger part, a ring finger part and a pinky finger part, and in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.3 mm in the X direction and ±12.6 mm in the Y direction around a coordinate (X, Y)=(0 mm, 8 mm) in the XY coordinate system.

A fourth aspect of the present invention relates to a hand phantom manufacturing method, comprising: (a) processing statistical data regarding a position of a thumb in a first holding pattern of holding a mobile apparatus and determining a first average position and a first standard deviation of the thumb relative to a center of a pointing device array in the mobile apparatus; (b) processing statistical data regarding a position of the thumb in a second holding pattern of holding the mobile apparatus and determining a second average position and a second standard deviation of the thumb relative of the center of the pointing device array; and (c) determining an arranged position of the thumb based on at least one of the first average position and the second average position and the first standard deviation and/or the second standard deviation corresponding to the at least one of the first average position and the second average position and manufacturing a hand phantom for evaluating the mobile apparatus.

The first through fourth aspects are described in detail below.

The inventors have obtained statistical data regarding finger positions of a hand holding various types of mobile apparatuses (including clam-shell type, slide type and straight type of mobile apparatuses) having data communication capability from randomly selected 150 people of different genders aged 18 and over in order to comprehend the specific finger positions of users holding the mobile apparatuses in use for data communications. In the statistical data, the finger positions are generally determined in positional relationship relative to a decision key (alternatively, a multifunction key, a scroll key or others) disposed in the center of the mobile apparatus body or relative to the center of a pointing device array including several function keys. From the statistical data, it has been found that the finger positions can be roughly classified into two patterns in the data communication mode independently of the different types of mobile apparatuses.

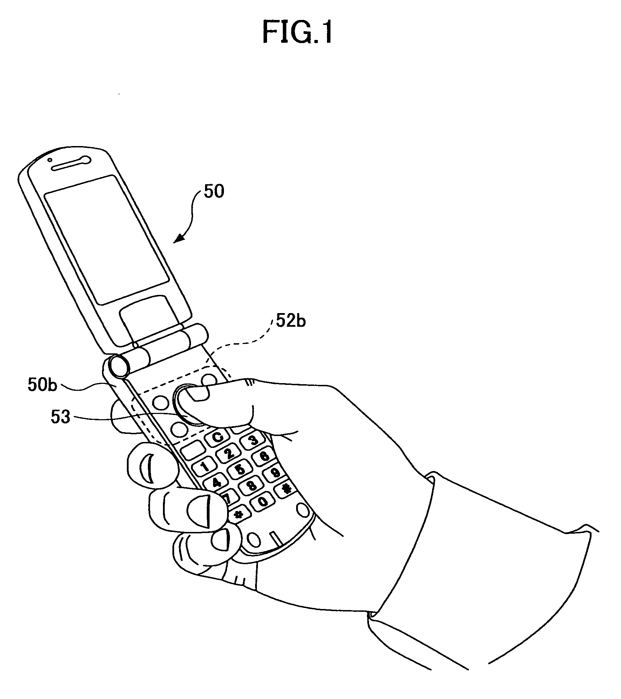

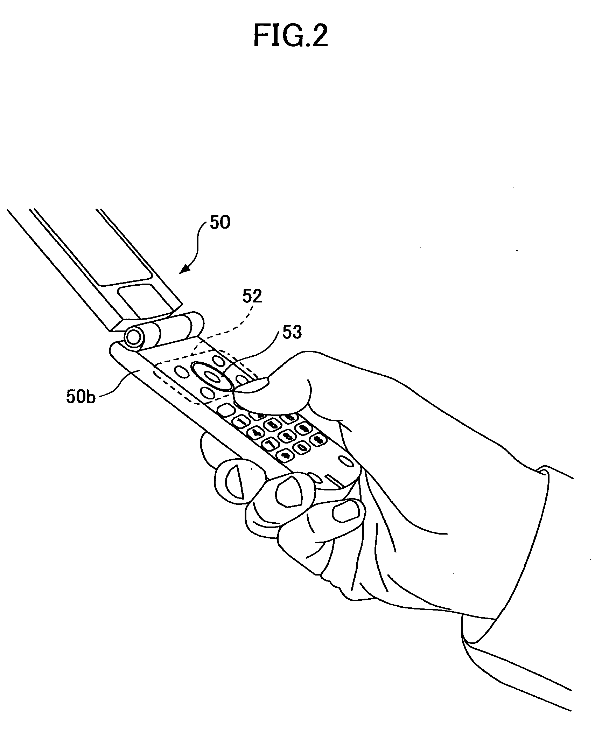

FIGS. 1 and 2 illustrate holding patterns 1 and 2, respectively, of a mobile apparatus being used in the data communication mode. In holding pattern 1 in FIG. 1, the ball portion of the pinky finger is attached to the body 50b of the mobile apparatus 50 during supporting the mobile apparatus 50. This holding pattern can be often observed particularly in screen switching or scrolling, and users may not usually intend to input data in holding pattern 1. On the other hand, in holding pattern 2 in FIG. 2, the ball of the pinky finger is not attached to the body 50b of the mobile apparatus 50 during supporting the mobile apparatus 50. This holding pattern can be often used for emails or data inputs such as inputting passwords to enter certain sites.

In holding patterns 1 and 2, the finger positions and/or error ranges thereof are different from each other and may differently affect antenna performance of an antenna embedded in the mobile apparatus 50. The mobile apparatus 50 is illustratively held by the right hand in FIGS. 1 and 2, but the difference as to whether the mobile apparatus 50 is held by the right hand or the left hand may not be significant except a symmetric appearance of the finger positions.

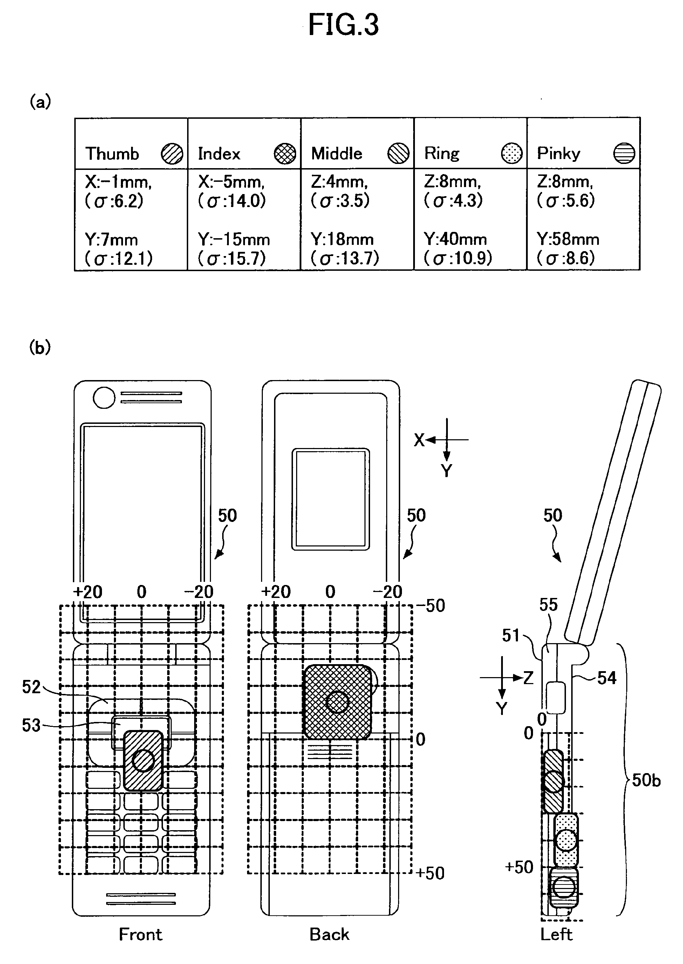

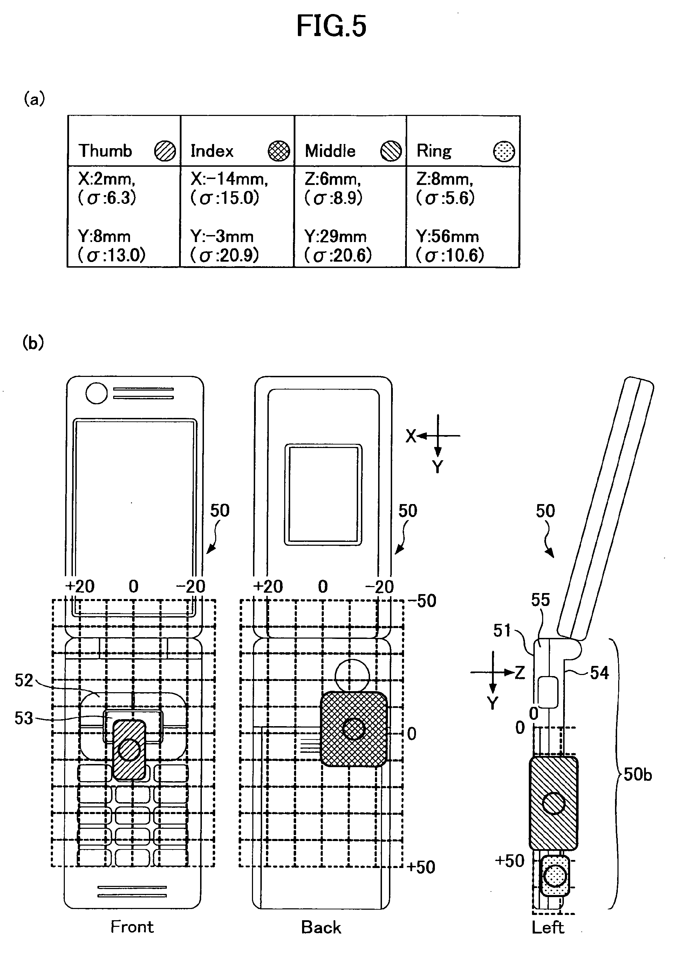

FIGS. 3 and 5 illustrate finger positions and error ranges (standard deviations) σ derived from some operations on the statistical data in holding patterns 1 and 2, respectively. In these illustrations, the orientation of the tip of the thumb of the holding hand in the width (lateral) direction of the body 50b of the mobile apparatus 50 is defined as +X direction, and the downward direction with respect to the longitudinal direction of the mobile apparatus body is defined as +Y direction. Assuming that the mobile apparatus 50 is held by the right hand in FIGS. 3 and 5, the left direction corresponds to +X direction in the drawings. The position of the index finger is represented by a coordinate value under the state where the back surface of the body 50b is oriented upward in the same direction as the front surface on the XY coordinate plane. Thus, if the mobile apparatus 50 is held under the state where the front surface 54 is oriented upward, the X coordinate value of the index finger would have an inverted sign (+ or -). Also, the thickness direction from the back surface 51 of the body 50b is defined as +Z direction.

FIG. 3(a) illustrates an exemplary table for numerically illustrating respective coordinate positions and σ ranges of the thumb, the index finger, the middle finger, the ring finger and the pinky finger in holding pattern 1. FIG. 3(b) illustrates respective positions of the fingers being put on the body 50b of the mobile apparatus 50 by circles and the σ error ranges by squares surrounding the circles. The finger positions are indicated as distance between the decision key 53 disposed in the center of the pointing device array 52 and ball positions of the respective fingers, more specifically, the middle positions of the fingers between the tip and the last joint or the positions in ball side of the fingers corresponding to the center of respective nails. Even if the pointing device array 52 and/or individual keys in the array 52 are shaped as circles, ellipses, squares, crosses, diamonds or others depending on types of mobile apparatuses, the center of the pointing device array 52 is defined as a coordinate origin. In the pointing device array 52 for a typical mobile apparatus (cellular phone), the decision key 53 having a diameter of about 5-10 mm is positioned at the center, and several function keys are positioned around the decision key 53 within 20-30 mm.

When considering influences of the hand on the antenna performance, the thumb position is one of important factors. The reason is that determination of the thumb position leads to determination of approximate positions of the other fingers. For an embedded antenna (not shown), there are influences of reflection and absorption from not only the front surface 54 of the body 50b but also the back surface 51 or the side surface 55 in the mobile apparatus 50, and thus the specific positional relationship among the other four fingers is also important. In particular, the position of the index finger on the back surface 51 of the mobile apparatus 50 as well as the thumb position on the front surface 54 of the mobile apparatus 50 works as a factor for determining an approximate shape of the hand.

In holding pattern 1 in FIG. 3(a), if the center of the decision key 53 is defined as a coordinate origin, the position of the thumb ball (the center position of the thumb between the tip and the last joint, which are simply referred to as "finger position") is represented as the coordinate (X, Y)=(-1 mm, 7 mm) in the XY plane. Alternatively, the thumb ball is positioned within the range (σ) of ±6.2 mm in the X direction and ±12.1 mm in the Y direction around that coordinate position.

The index finger is positioned at the coordinate (X, Y)=(-5 mm, -15 mm) in a coordinate system under the state where the mobile apparatus 50 is reversed or the back surface 51 is turned upward. Alternatively, the index finger is positioned within the range (σ) of ±14.0 mm in the X direction and ±15.7 mm in the Y direction around that coordinate position. In a coordinate system in the state where the front surface 54 of the mobile apparatus 50 is turned upward, the index finger is positioned at the coordinate (X, Y)=(5 mm, -15 mm).

If the back surface 51 of the body 50b is defined as Z=0 mm and the Y directional position of the decision key 53 is defined as Y=0 mm, the middle finger is positioned on the side surface 55 of the body 50b at the coordinate (Z, Y)=(4 mm, 18 mm) on the ZY plane. Alternatively, the middle finger is positioned within the range (σ) of ±3.5 mm in the X direction and ±13.7 mm in the Y direction around that coordinate position.

The ring finger is positioned at the coordinate (Z, Y) = (8 mm, 40 mm) on the ZY plane or within the range (σ) of ±4.3 mm in the X direction and ±10.9 mm in the Y direction around that coordinate position.

The pinky finger is positioned at the coordinate (Z, Y) = (8 mm, 58 mm) on the ZY plane or within the range (σ) of ±5.6 mm in the X direction and ±8.6 mm in the Y direction around that coordinate position.

In this manner, in holding pattern 1 where the pinky ball is attached to the mobile apparatus 50, the index finger ball is positioned relatively near the center of the body 50b in the X (width) direction, and the pinky finger ball is positioned near the bottom edge of the side surface 55 of the mobile apparatus 50.

Instead of absolute values from the finger positions, the above σ error ranges can be also represented as a ratio to the size of the pointing device array 52 of the mobile apparatus 50, for example, as 60 % of the size of the pointing device apparatus 52.

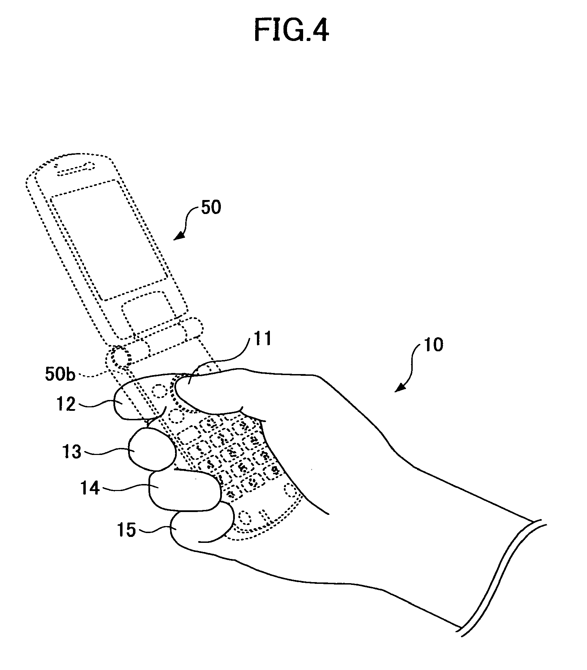

FIG. 4 schematically illustrates a hand phantom 10 designed based on the statistical data in FIG. 3. The hand phantom 10 includes a thumb 11, an index finger 12, a middle finger 13, a ring finger 14 and a pinky finger 15 and is shaped to hold an arbitrary mobile apparatus 50. The fingers 11-15 are arranged such that the positional relationship among the fingers 11-15 with respect to the center of a pointing device array of the mobile apparatus body 50b satisfies the relationship as illustrated in FIG. 3. In other words, the respective fingers are arranged within the σ ranges around the coordinate positions as illustrated in FIG. 3(a). The hand phantom 10 is preferably formed of flexible or elastic materials equivalent to human body, and the respective fingers 11-15 may be arranged at the coordinate positions as illustrated in FIG. 3 and be movable within the σ ranges.

FIG. 5(a) illustrates an exemplary table for numerically illustrating coordinate positions and σ ranges of a thumb, an index finger, a middle finger and a ring finger in holding pattern 2. In FIG. 5(b), the respective finger positions on the body 50b of the mobile apparatus 50 are represented as circles, and the σ error ranges are represented as squares surrounding the circles. Similar to FIG. 3, the finger position is indicated as the finger ball position relative to the decision key 53 disposed at the center of the pointing device array 52, more specifically, as the center of the finger between the tip and the last joint or the position in the finger ball corresponding to the center of the nail.

In holding pattern 2 in FIG. 5(a), if the center of the decision key 53 is defined as a coordinate origin, the thumb ball is positioned at the coordinate (X, Y)=(2 mm, 8 mm) on the XY plane or within the range (σ) of ±6.3 mm in the X direction and ±13.0 mm in the Y direction around that coordinate position.

In a coordinate system in a state where the mobile apparatus 50 is reversed and the back surface 51 is turned upward, the index finger is positioned the coordinate (X, Y)=(-14 mm, -3 mm) or within the range (σ) of ±15.0 mm in the X direction and ±20.9mm in the Y direction around that coordinate position. In a coordinate system under the stated where the mobile apparatus front surface 54 is turned upward, the index finger is positioned at the coordinate (X, Y)=(14 mm, -3 mm).

If the back surface 51 of the body 50b is defined as Z=0 mm and the Y directional position of the decision key 53 is defined as Y=0 mm, the middle finger is positioned on the side surface 55 of the body 50b at the coordinate (Z, Y)=(6 mm, 29 mm) on the ZY plane. Alternatively, the middle finger is positioned within the range (σ) of ±8.9 mm in the X direction and ±20.6 mm in the Y direction around that coordinate position.

The ring finger is positioned at the coordinate (Z, Y) = (8 mm, 56 mm) on the ZY plane or within the range (σ) of ±5.6 mm in the X direction and ±10.9 mm in the Y direction around that coordinate position.

In this manner, in holding pattern 2 where the pinky finger is not attached to the mobile apparatus 50, the ball position of the index finger is shifted by about 10 mm in the -X direction on the coordinate axis in FIG. 5(b) (in the +X direction in actual usage states). Also, similar to FIG. 3, the above σ error ranges of the respective fingers may be represented as a ratio to the size of the pointing device array 52 of the mobile apparatus 50 instead of absolute values from the finger positions.

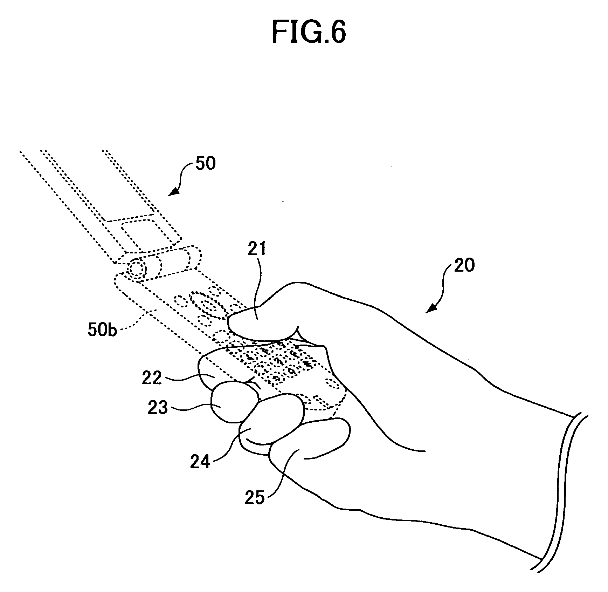

FIG. 6 schematically illustrates a hand phantom 20 designed based on the statistical data in FIG. 5. The hand phantom 20 includes a thumb 21, an index finger 22, a middle finger 23, a ring finger 24 and a pinky finger 25 and are shaped to hold an arbitrary mobile apparatus 50. However, the hand phantom 20 is designed such that the ball of the pinky finger 25 is not touched to the side surface of the mobile apparatus 50. The respective fingers 21-24 are arranged within the σ ranges around the respective coordinate positions such that the positional relationship among the fingers 21-24 with respect to the center of the pointing device array of the mobile apparatus body 50b to be measured satisfies the relationship as illustrated in FIG. 5. The hand phantom 20 is preferably formed of flexible or elastic materials equivalent to human body, and the respective finger 21-24 may be movable within the σ ranges in FIG. 5.

According to the above embodiments, even if the mobile apparatus 50 is used in the data communication mode, the different hand phantoms 10 and 20 are provided corresponding to the cases where the mobile apparatus 50 is mainly used for screen switching or scrolling such as Web browsing (holding pattern 1) and for data input (holding pattern 2), which enables the antenna performance (radio characteristics) of the mobile apparatus 50 to be evaluated more accurately.

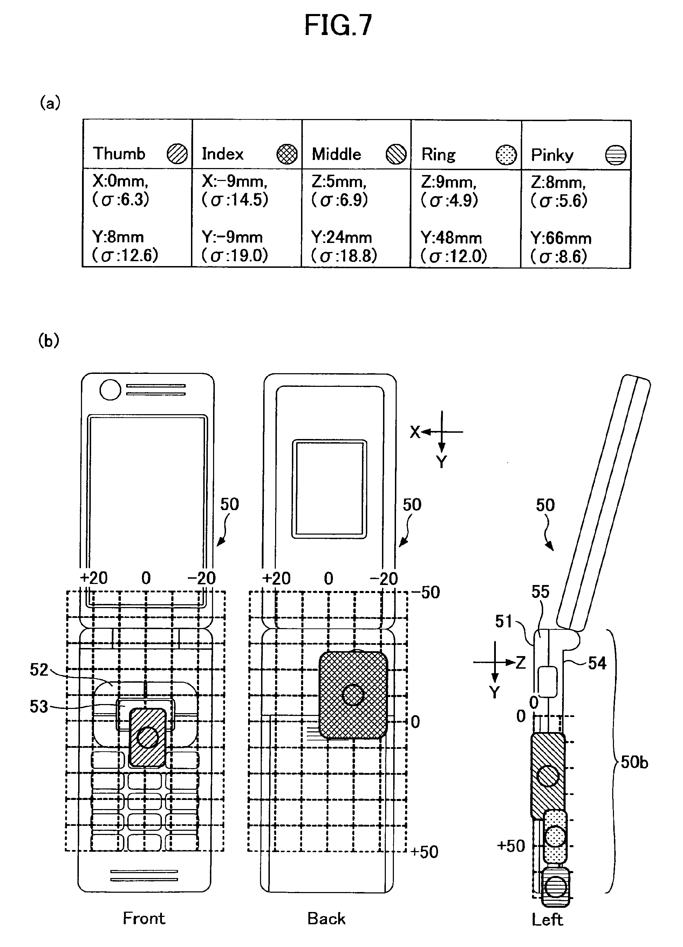

FIG. 7 illustrates an exemplary combination of the statistical data in FIG. 3 and the statistical data in FIG. 5. Instead of the two types of hand phantoms as illustrated in FIGS. 4 and 6, a hand phantom (not shown) designed based on the combined statistical data as illustrated in FIG. 7 can handle both holding pattern 1 and holding pattern 2 through averaging of holding patterns 1 and 2. The statistical data can be used to reduce the number of hand phantoms for use in measuring evaluation and the number of evaluation steps.

FIG. 7(a) illustrates an exemplary table for numerically illustrating coordinate positions and σ ranges of an averaged index finger, an averaged middle finger, an averaged ring finger and an averaged pinky finger. In FIG. 7(b), the respective finger positions on the body 50b of the mobile apparatus 50 are illustrated as circles, and the σ error ranges are illustrated as squares surrounding the circles. Similar to FIGS. 3 and 5, the finger position is represented as distance between the decision key 53 disposed at the center of the pointing device array 52 and the finger ball position, more specifically, the center of the finger between the tip and the last joint or the position in the finger ball side corresponding to the nail center.

In FIG. 7(a), if the center of the decision key 53 is defined as a coordinate origin, the thumb ball position (the center in the thumb between the tip and the last joint, which is simply referred to as a "finger position") is at the coordinate (X, Y)=(0 mm, 8 mm) on the XY plane. Alternatively, the thumb ball is positioned within the range (σ) of ±6.3 mm in the X direction and +12.6 mm in the Y direction around that coordinate position.

The index finger is positioned at the coordinate (X, Y)=(-9 mm, -9 mm) or within the range (σ) of ±14.5 mm in the X direction and ±19.0 mm in the Y direction around that coordinate position. In a coordinate system where the front surface 54 of the mobile apparatus 50 is turned upward, the index finger is positioned at the coordinate (X, Y)=(9 mm, -9 mm).

If the back surface 51 of the body 50b is defined as Z=0 mm and the Y directional position of the decision key 53 is defined as Y=0 mm, the middle finger is positioned on the side surface 55 of the body 50b at the coordinate (Z, Y)=(5 mm, 24 mm) on the ZY plane. Alternatively, the middle finger is positioned within the range (σ) of ±6.9 mm in the X direction and ±18.8 mm in the Y direction around that coordinate position.

The ring finger is positioned at the coordinate (Z, Y) = (9 mm, 48 mm) on the ZY plane or within the range (σ) of ±4.9 mm in the X direction and ±12.0 mm in the Y direction around that coordinate position.

The pinky finger is positioned at the coordinate (Z, Y) = (8 mm, 66 mm) on the ZY plane or within the range (σ) of ±5.6 mm in the X direction and ±8.6 mm in the Y direction around that coordinate position.

Although not illustrated, a hand phantom designed based on the above statistical data are arranged such that the thumb, the index finger, the middle finger, the ring finger and the pinky finger are positioned within the σ ranges around the respective coordinate positions. Alternatively, the respective fingers may be positioned at the coordinate positions and be movable within the σ ranges.

As stated above, according to the embodiments of the present invention, the hand phantoms more suitable for actual usage of a mobile apparatus such as a cellular phone can be provided and used to evaluate the antenna characteristics and radio performance.

This international patent application is based on Japanese Priority Application No. 2007-211845 filed on August 15, 2007, the entire contents of which are hereby incorporated by reference.

## Claims

1. A hand phantom for evaluating a mobile apparatus, wherein
the hand phantom includes a thumb part, an index finger part, a middle finger part, a ring finger part and a pinky finger part, and
in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.2 mm in the X direction and ±12.1 mm in the Y direction around a coordinate (X, Y)=(-1 mm, 7 mm) in the XY coordinate system.

2. The hand phantom as claimed in claim 1, wherein the index finger part is arranged within a range of ±14.0 mm in the X direction and ±15.7 mm in the Y direction around a coordinate (X, Y)=(5 mm, -15 mm) in the XY coordinate system.

3. The hand phantom as claimed in claim 1, wherein the pinky finger part is arranged within a range of ±5.6 mm in a Z direction and ±8.6 mm in the Y direction around a coordinate (Z, Y) = (8 mm, 58 mm) in a ZY coordinate system where a thickness direction from a back surface of the mobile apparatus is defined as the Z direction and a center of the pointing device array on the back surface is defined as a coordinate origin.

4. A hand phantom for evaluating a mobile apparatus, wherein
the hand phantom includes a thumb part, an index finger part, a middle finger part, a ring finger part and a pinky finger part,
the pinky finger part is arranged such that a ball of the pinky finger part is prevented from touching to a side surface of the mobile apparatus in measurement of the mobile apparatus, and
in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.3 mm in the X direction and ±13.0 mm in the Y direction around a coordinate (X, Y)=(2 mm, 8 mm) in the XY coordinate system.

5. The hand phantom as claimed in claim 4, wherein the index finger part is arranged within a range of ±15.0 mm in the X dire-ction and +20.9 mm in the Y direction around a coordinate (X, Y)=(14 mm, -3 mm) in the XY coordinate system.

6. A hand phantom for evaluating a mobile apparatus, wherein
the hand phantom includes a thumb part, an index finger part, a middle finger part, a ring finger part and a pinky finger part, and
in an XY coordinate system where for the mobile apparatus being held, an orientation of a thumb along a width direction of the mobile apparatus is defined as a +X direction, an orientation of a bottom edge of the mobile apparatus along a longitudinal axis of a body of the mobile apparatus is defined as a +Y direction, and a center of a pointing device array of the mobile apparatus is defined as a coordinate origin, the thumb part is arranged within a range of ±6.3 mm in the X direction and ±12.6 mm in the Y direction around a coordinate (X, Y)=(0 mm, 8 mm) in the XY coordinate system.

7. The hand phantom as claimed in claim 6, wherein the index finger part is arranged within a range of ±14.5 mm in the X direction and ±19.0 mm in the Y direction around a coordinate (X, Y)=(9 mm, -9 mm) in the XY coordinate system.

8. The hand phantom as claimed in claim 6, wherein the pinky finger part is arranged within a range of ±5.6 mm in a Z direction and ±8.6 mm in the Y direction around a coordinate (Z, Y) = (8 mm, 66 mm) in a ZY coordinate system where a thickness direction from a back surface of the mobile apparatus is defined as the Z direction and a center of the pointing device array on the back surface is defined as a coordinate origin.

9. A hand phantom manufacturing method, comprising:
processing statistical data regarding a position of a thumb in a first holding pattern of holding a mobile apparatus and determining a first average position and a first standard deviation of the thumb relative to a center of a pointing device array in the mobile apparatus;
processing statistical data regarding a position of the thumb in a second holding pattern of holding the mobile apparatus and determining a second average position and a second standard deviation of the thumb relative of the center of the pointing device array; and
determining an arranged position of the thumb based on at least one of the first average position and the second average position and the first standard deviation and/or the second standard deviation corresponding to the at least one of the first average position and the second average position and manufacturing a hand phantom for evaluating the mobile apparatus.

10. The hand phantom manufacturing method as claimed in claim 9, wherein
the first holding pattern corresponds to a holding aspect where a ball of a pinky finger is attached to the mobile apparatus, and
the second holding pattern corresponds to a holding aspect where the ball of the pinky finger is not attached to the mobile apparatus.
